(19) **Europäisches Patentamt**

**European Patent Office**

**Office européen des brevets**

(11) Veröffentlichungsnummer: **0 249 298 B1**

(12) # EUROPÄISCHE PATENTSCHRIFT

(45) Veröffentlichungstag der Patentschrift: **28.10.92**

(51) Int. Cl.⁵: **G01R 33/34**

(21) Anmeldenummer: **87201092.1**

(22) Anmeldetag: **10.06.87**

(54) **Oberflächenspule für Hochfrequenzmagnetfelder bei Kernspinuntersuchungen.**

(30) Priorität: **13.06.86 DE 3619970**

(43) Veröffentlichungstag der Anmeldung:
**16.12.87 Patentblatt 87/51**

(45) Bekanntmachung des Hinweises auf die
Patenterteilung:
**28.10.92 Patentblatt 92/44**

(84) Benannte Vertragsstaaten:
**DE FR GB NL**

(56) Entgegenhaltungen:
**EP-A- 0 154 360**
**EP-A- 0 175 129**
**DE-A- 3 608 473**
**DE-B- 2 225 899**

(73) Patentinhaber: **Philips Patentverwaltung GmbH**
**Wendenstrasse 35 Postfach 10 51 49**
**W-2000 Hamburg 1(DE)**

(84) Benannte Vertragsstaaten:
**DE**

(73) Patentinhaber: **N.V. Philips' Gloeilampenfabrieken**
**Groenewoudseweg 1**
**NL-5621 BA Eindhoven(NL)**

(84) Benannte Vertragsstaaten:
**FR GB NL**

(72) Erfinder: **Röschmann, Peter**
**Steenbalken 13**
**W-2000 Hamburg 63(DE)**

(74) Vertreter: **Hartmann, Heinrich, Dipl.-Ing. et al**
**Philips Patentverwaltung GmbH Wendenstrasse 35 Postfach 10 51 49**
**W-2000 Hamburg 1(DE)**

EP 0 249 298 B1

## Beschreibung

Die Erfindung bezieht sich auf eine Oberflächenspule für Hochfrequenzmagnetfelder bei Kernspinuntersuchungen mit wenigstens einer in wenigstens zwei kapazitiv miteinander gekoppelte und vorzugsweise gleich lange Teile aufgeteilten Schleife.

Eine solche Oberflächenspule ist aus dem Book of Abstracts, Vol. 2, Society of Magnetic Resonance in Medicine, Forth Annual Meeting, August 19-23, 1985, London, Seiten 1084 und 1085 sowie Seiten 1117 und 1118 bekannt.

Oberflächenspulen dieser Art können bei Kernspinuntersuchungen, insb. für medizinische Zwecke, zum Erzeugen hochfrequenter magnetischer Felder oder zum Empfangen von Kernspin-Resonanzsignalen benutzt werden. Sie befinden sich insbesondere bei medizinischen Anwendungen an der Oberfläche eines zu untersuchenden medizinschen Körpers, wodurch ihre Güte verringert wird. Aus den eingangs genannten Veröffentlichungen ist es bekannt, daß die Güte einer Spule dadurch verbessert werden kann, daß die Schleife, die die Spule bildet, in wenigstens zwei Teile aufgeteilt wird, die kapazitiv miteinander gekoppelt sind.

Die Einspeisung (oder die Entnahme) der Hochfrequenzenergie erfolgt dabei in der Regel am Trennspalt zwischen zwei benachbarten Schleifenteilen, und zwar über ein Abstimm- und Anpaßnetzwerk. Eine Veränderung der Anpassung und der Abstimmung hat eine elektrische Unsymmetrie zur Folge, die zu einer Verringerung der Spulengüte führt. Ein weiterer Nachteil der bekannten Anordnung ist, daß die Trennspalte genügend groß sein müssen, um zwischen den beiden Schleifenteilen die erforderlichen Kondensatoren anzuordnen, die insbesondere bei Verwendung der Oberflächenspule als Sendespule eine relativ hohe Spannungsfestigkeit erfordern und daher relativ groß sind. Im Bereich der Trennspalte enstehen daher relativ starke Verzerrungen der Feldverteilung.

Aufgabe der vorliegenden Erfindung ist es, eine vorteilhafte Ausgestaltung einer Oberflächenspule der eingangs genannten Art anzugeben.

Diese Aufgagbe wird erfindungsgemäß dadurch gelöst, daß der eine Schleifenteil einen Außenleiter umfaßt, der zwei davon isolierte Innenleiter umschließt, deren einer Anschluß jeweils symmetrisch zu diesem Schleifenteil herausgeführt ist und deren anderer Anschluß jeweils galvanisch mit dem Leiter bzw. den Leitern des benachbarten Schleifenteils bzw. der benachbarten Schleifenteile gekoppelt ist.

Bei der Erfindung wird die Kapazität zwischen zwei Schleifenteilen durch die Kapazität gebildet, die der aus dem Außenleiter herausragende Innenleiter gegenüber dem zugehörigen Außenleiter aufweist. Dies erlaubt es, die Trennstellen bzw. Zwischenräume zwischen benachbarten Schleifenteilen relativ kurz zu machen, z.B. 2 bis 3 mm. Dadurch ergeben sich nur geringe Verzerrungen der elektromagnetischen Felder an den Trennstellen.

Bei der Erfindung ergibt sich eine zu den Mitten der Schleifenteile symmetrische Feldverteilung. Diese Mitten können daher als virtuelle Massepunkte angesehen werden. Im Bereich dieser Massepunkte wirksame elektrische Komponenten oder Leiter haben kaum einen Einfluß auf die Feldverteilung der Oberflächenspule, so daß die Hochfrequenzzuleitungen für die Spule, die sich bei der erfindungsgemäßen Oberflächenspule im Bereich dieser virtuellen Massenpunkte befinden, die Symmetrie der Feldverteilung aber nicht beeinflussen. Je besser jedoch diese Symmetrie ist, desto geringer sind die dielektrischen Verluste und desto besser werden unerwünschte sog. Mantelwellen auf den Hochfrequenzzuleitungen unterdrückt. Diese Mantelwellen können sich in dem Raum zwischen dem Mantel der Hochfrequenzzuleitung und leitenden Flächen (z. B. einem Faradayschirm) innerhalb eines Kernspinuntersuchungsgerätes ausbreiten. Wenn aber die Hochfrequenzzuleitung der Spule an einen virtuellen Massepunkt geführt wird, wie bei der Erfindung, können solche Mantelwellen nicht angeregt werden.

Geeignete Formen für die die Oberflächenspule bildende Schleife sind die Kreisform oder die Rechteckform. Es können jedoch auch andere Formen sein, wobei es lediglich darauf ankommt, daß die Form symmetrisch zu einer den einen Schleifenteil im Zentrum senkrecht schneidenden Symmetrieebene ist.

In der Regel besitzt eine Oberflächenspule nur eine einzige Schleife. Jedoch ist es auch möglich, eine Oberflächenspule durch zwei nebeneinander liegende Schleifen zu bilden, die einen Schleifenteil gemeinsam haben und die zwei senkrecht zur Schleifenebene einander entgegengerichtete Magnetfelder erzeugen, die nur im Nahberich wirksam sind, sich im Fernbereich jedoch kompensieren.

Eine bevorzugte Weiterbildung der Erfindung sieht vor, daß der eine Schleifenteil zwei etwa gleich lange Koaxialleitungen umfaßt, von denen jeweils annähernd gleich lange Teile zusammen den einen Schleifenteil bilden, und daß die verbleibenden Teile der Koaxialleitungen nebeneinander und symmetrisch zu dem einen Schleifenteil verlaufen. An das Ende der verbleibenden Teile der Koaxialleitungen, das sich in einiger Entfernung von der Schleife befindet, kann der Hochfrequenzgenerator bzw. Empfänger oder ein Anpaß-und Abstimmnetzwerk angeschlossen werden, ohne daß dadurch die Feldverteilung der Oberflächenspule wesentlich beeinflußt wird.

Die Erfindung wird nachstehend anhand der Zeichnung näher erläutert. Es zeigen:

Fig. 1
ein Ausführungsbeispiel mit einer zweiteiligen kreisförmigen Schleife,
Fig. 2a und 2b
ein Ausführungsbeispiel mit einer rechteckigen Schleife,
Fig. 3
eine erste Ausführungsform mit einer vierteiligen kreisförmigen Schleife, und
Fig. 4
eine zweite Ausführungsform mit einer vierteiligen kreisförmigen Schleife.

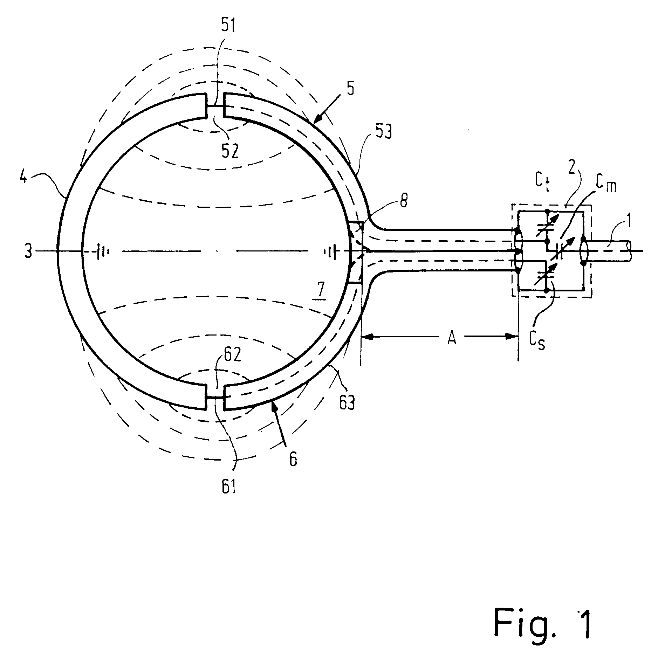

Die in Fig. 1 dargestellte Oberflächenspule besitzt eine zweiteilige kreisförmige Schleife. Der eine Schleifenteil 7 wird durch zwei gleich lange Koaxialkabel gebildet, deren einer Teil jeweils entsprechend einem Viertelkreis gebogen ist, so daß beide Teile zusammen etwa einen Halbkreis bilden. Die verbleibenden Teile der beiden Koaxialkabel verlaufen nebeneinander und symmetrisch zu dem Halbkreis. Der andere Schleifenteil 4 hat ebenfalls die Form eines Halbkreises und besteht aus einem leitenden Rohr bzw. aus einem massiven Leiter, beispielsweise aus Kupfer. Der Außendurchmesser des Schleifenteils 4 entspricht dem Durchmesser der Außenleitungen 53 bzw. 63 der Koaxialkabel 5 bzw. 6.

Der Schleifenteil 4 ist mit dem aus dem Außenleiter 53 bzw. 63 des Koaxialkabels 5 bzw. 6 herausragenden Ende des Innenleiters 51 bzw. 61 des Koaxialkabels 5 bzw. 6 verbunden. Zwischen den Enden des Außenleiters 53 bzw. 63 einerseits und dem Schleifenteil 4 andererseits verbleibt dabei ein Spalt von etwa 2 bis 3 mm; dieser Trennspalt kann zur Verbesserung der mechanischen Stabilität der Oberflächenspule mit einem Kunststoff ausgefüllt sein.

Das von dem Schleifenteil 4 abgewandte Ende des Innenleiters 52 ist über einen Anpaßkondensator Cm mit dem Innenleiter eines weiteren Koaxialkabels 1 verbunden, das zu dem Eingang eines nicht näher dargestellten Hoch-frequenzempfängers oder Hochfrequenzerzeugers führt. Außerdem ist zwischen den Innenleiter 51 und den Außenleiter 53 des Koaxialkabels 5 ein Abstimmkondensator Ct geschaltet. Zwischen Innen- und Außenleiter des anderen Koaxialkabels ist ein Kondensator Cs geschaltet, dessen Kapazität zumindest annähernd der Summe der Kapazitäten der Kondensatoren Ct und Cm entspricht. Dadurch werden die beiden Innenleiter 51 und 61 in gleicher Weise kapazitiv belastet. Vorzugsweise befinden sich die Kondensatoren in einer mit den Außenleitern der Koaxialkabel 1, 5 und 6 leitend verbundenen, elektrisch leitenden geerdeten Abschirmung 2.

Die Kapazität, die zwischen den Schleifenteilen 4 und 7 wirksam ist, entspricht der Kapazität zwischen dem mit dem Schleifenteil 4 verbundenen Innenleiter 51 bzw. 61 und dem zugehörigen Außenleiter 53 bzw. 63, die noch durch die Kondensatoren Ct und Cm bzw. Cs vergrößert wird. Wenn daher beispielsweise mit der Oberflächenspule elektro-magnetische Felder erzeugt werden, ist die Generatorspannung über den Spalten 52 bzw. 62 zwischen den Schleifenteilen 4 und 7 wirksam. Daraus resultiert ein mit gestrichelten Linien angedeuteter zu einer Symmetrieebene 3 symmetrischer Verlauf der elektrischen Feldlinien. Die Symmetrieebene 3, die auch eine geometrische Symmetrieebene ist, verbindet die Mitten der Schleifenteile 4 und 7; der von dem Schleifenteil 7 abgebogene Teil der Koaxialkabel 5 und 6 grenzt mit seinem Außenleiter an die zur Zeichenebene der Fig. 1 senkrechte Symmetrieebene. Die Schnittbereiche dieser Symmetrieebene mit der Schleife 4, 7 sind daher frei von elektrischen Feldern und können als virtuelle Massepunkte betrachtet werden. Elektrische Leiter, die sich in diesem Bereich befinden - u.a. die Abschirmung 2 und der zu dem Schleifenteil 7 führende Teil der Koaxialkabel 5 und 6 - , haben daher auf die Feldverteilung in der Spule praktisch keinen Einfluß. Infolgedessen ist die Anregung der sogenannten Mantelwellen in diesem Bereich unterdrückt bzw. bei in der Praxis unvermeidbaren Symmetrieabweichungen erheblich reduziert im Vergleich zu einer Spule, bei der die Hochfrequenzzuleitung direkt zum Trennspalt, also zu einem Ort mit hoher elektrischer Feldstärke, geführt wird.

Die Resonanzfrequenz der Oberflächenspule sowie die Anpassung werden bei Kernspinuntersuchungen in unterschiedlicher Weise durch die Lage der Spule zum Körper des Patienten und durch die Eigenschaften des Patientengewebes beeinflußt. Es ist daher zweckmäßig, den Kondensator Cs einmalig für eine mittlere Patientenbelastung bei einer vorgegebenen Resonanzfrequenz einzustellen und die genaue Einstellung der Resonanzfrequenz und der Anpassung bei jeden Untersuchung durch Einstellen der Kondensatoren Ct und Cm vorzunehmen. Die dabei entstehenden geringen elektrischen Unsymmetrien können bei der erfindungsgemäßen Spulenausführung vernachlässigt werden.

Die Länge der beiden Koaxialkabel sollte einerseits nicht wesentlich größer als 1/8 der Wellenlänge im Kabel bei der Resonanzfrequenz sein, und der Abstand A, der nebeneinander liegenden Enden der Koaxialkabel von der Mitte der Schleife 7 sollte zwischen 20 und 200 mm liegen. Der Abstand A kann dabei bei unterschiedlichen Schleifendurchmessern und Resonanzfrequenzen durch geeignete Wahl der Dicke der Leiterschleifen, der außen zugeschalteten Kondensatoren Ct, Cs und Cm, des Innendurchmessers des Außenleiters und des Außendurchmessers des Innenleiters dieses Kabels und des Dielektrikums dieser Forderung in einem weiten Bereich angepaßt werden.

Als Koaxialkabel 5 und 6 eignen sich wegen ihrer mechanischen Stabilität insbesondere sogenannte Festmantelkabel vorzugsweise aus Kupfer. Durch die Biegeradien in dem Bereich, in dem die parallel geführten Kabel in die Schleife übergehen, ergibt sich eine Einbuchtung, die zu einer unerwünschten Feldverformung führen könnte. Diese läßt sich mittels eines Brückengliedes 8 aus beispielsweise Kupferfolie vermeiden, das die Außenleiter der beiden Koaxialleitungen elektrisch leitend überbrückt.

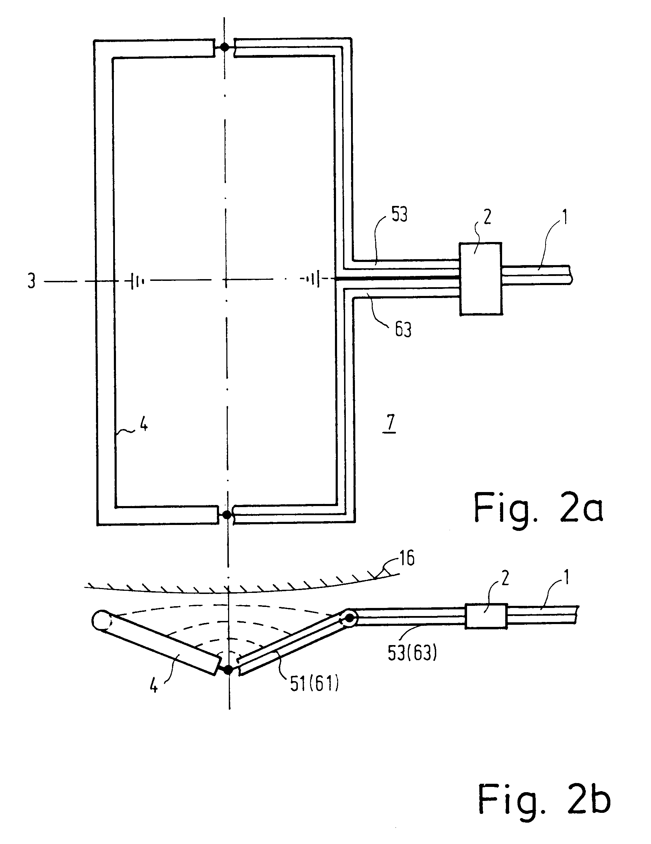

In Fig. 2a und 2b ist ebenfalls eine Oberflächenspule mit einer zweigeteilten Schleife dargestellt, wobei die Schleife jedoch eine Rechteckform aufweist, so daß zwei jeweils zur Mittellinie 3 symmetrische Rechteck-Schleifenteile enstehen. Wie insb. Fig. 2b zeigt, ist der Innenleiter 51 bzw. 61 über ein elektrisch leitendesDrehgelenk mit dem Leiter 4 verbunden. Durch Abknicken der Leiterschleife in den beiden Trennspalten kann der bereich hoher elektrischer Feldstärken vom Patienten 16 entfernt werden, wodurch die dielektrischen Verluste im Patienten reduziert werden. Wird der Winkel zwischen den beiden Schleifenteilen 4 und 7 verändert, ändert sich auch die Induktivität der Schleife. Deshalb ist es mit dieser Ausführungsform möglich, durch Ändern des Winkels eine Frequenznachstimmung herbeizuführen, ohne daß die Einstellung des Abstimmkondensators (und damit die elektrische Symmetrie der Schaltung) geändert wird. Durch größere Winkeländerungen kann die Breite des Bereiches, in dem mit dieser Oberflächenspule ein Hochfrequenzmagnetfeld erzeugt wird, erheblich beeinflußt und gewünschten Abbildungsbereichen im Körper angepaßt werden.

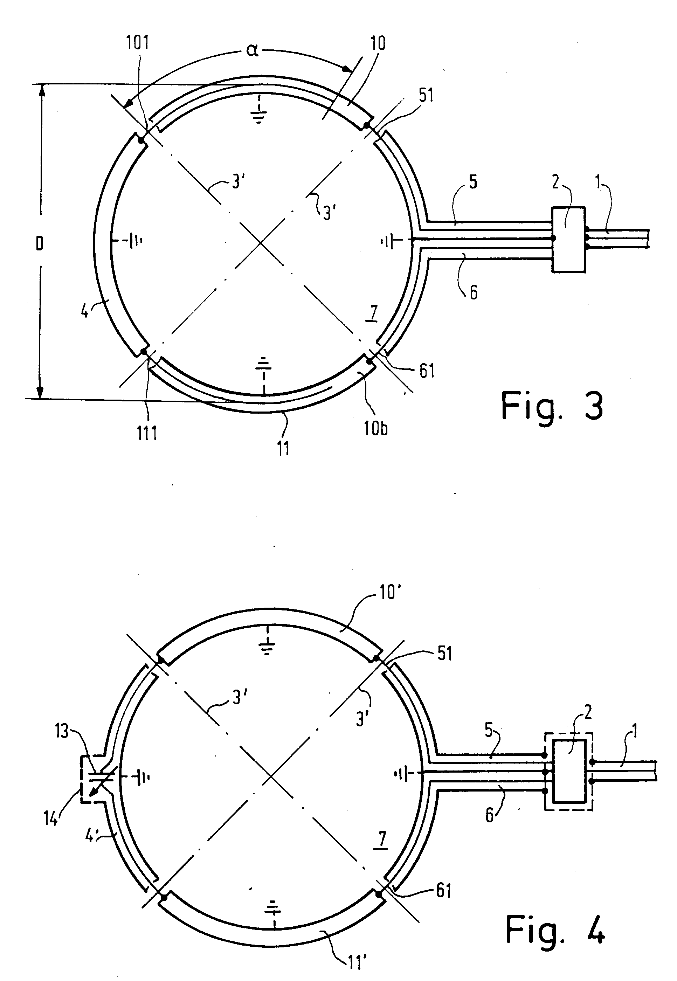

In Fig. 3 ist eine Oberflächenspule mit einer vierfach unterteilten kreisförmigen Schleife dargestellt. Jeder Schleifenteil entspricht dabei einem Kreisbogen von etwa 90°. Der mit dem Hochfrequenzerzeuger- oder -empfänger verbundene Schleifenteil 7 ist mit seinen beiden Innenleitern 51 bzw. 61 mit dem Außenleiten eines benachbarten Schleifenteils 10 bzw. 11 verbunden, der einen Innenleiter 101 bzw. 111 umschließt. Die beiden Innenleiter 101 bzw. 111 sind mit dem vierten Schleifenteil - einem massiven Leiterteil 4 - verbunden. Damit die Anordnung symmetrisch wird, müssen die Kapazitäten zwischen den Schleifenteilen 10 und 11 und dem Schleifenteil 4 die gleiche Größe haben wie die Kapazitäten zwischen den Schleifenteilen 10 und 11 und dem Schleifenteil 7. Damit dies erreicht wird, müssen die Kabel, aus denen die Schleifenteile 10 und 11 gebildet werden, den gleichen Aufbau haben und pro Längeneinheit eine größere Kapazität als die in dem Schleifenteil 7 benutzten Koaxialleitungen. Bei voller elektrischer Symmetrie der Anordnung, die nur für eine einzige Frequenz existiert, ergeben sich zwei jeweils durch gegenüberliegende Trennspalte verlaufende Symmetrieebenen 3', so daß die jeweiligen Mitten der Schleifenteile als virtuelle Masse betrachtet werden können.

Der Schleifenteil 7 kann grundsätzlich auf gleiche Weise aufgebaut sein, wie der entsprechende Schleifenteil in Fig. 1, mit dem einzigen Unterschied, daß er anstatt einem Halbkreisbogen einem Viertelkreisbogen entspricht. Der in Fig. 1 dargestellte Aufbau des Schleifenteils 7 setzt aber voraus, daß Koaxialleitungen vorhanden sind, die mit einem genügend kleinen Biegeradius, z.B 15 mm oder weniger, verformt werden dürfen. Bei größeren Biegeradien ist es sinnvoll, einen kreisbogenförmigen Außenleiter mit zwei getrennten Innenleitern zu verwenden, die im Bereich der Mitte des Kreisbogens mit zwei etwa senkrecht dazu verlaufenden Koaxialkabeln 5 und 6 verbunden sind.

In Fig. 4 ist eine weitere Oberflächenspule mit einer viergeteilten kreisförmigen Schleife dargestellt. Die Innenleiter 51 bzw. 61 sind dabei jedoch mit Schleifenteilen 10' bzw. 11' verbunden, die keinen Innenleiter aufweisen, sodern aus einem massiven Kupferleiter oder einem Kupferrohr bestehen. Der vierte Schleifenteil 4' besteht dabei ebenfalls aus einer Koaxialanordnung, deren Innenleiter jedoch in der Mitte aufgetrennt und an einen einstellbaren Kondensator 13 angeschlossen sind. Dessen Kapazität ist so zu bemessen, daß über den Trennspalten zwischen den Schleifenteilen 4' und 10' bzw. 4' und 11' die gleiche Kapazität wirksam ist, wie über den Trennspalten zwischen den Schleifenteilen 7 und 10' bzw. 7 und 11'. Um elektrische Felder im Bereich des Kondensators 13 vom Patienten abzuschirmen, kann dieser durch eine Aufweitung 14 des Kabelmantels elektrisch abgeschirmt sein. - Statt dessen ist es jedoch auch möglich, die Innenleiter des vierten Schleifenteils auf gleiche Weise aus dem Schleifenteil herauszuführen wie bei dem Schleifenteil 7 und die Enden der Innenleiter über einen entsprechend großen Kondensator miteinander zu verbinden, so daß sich die Symmetrie einstellt.

Vorstehend wurde die Erfindung anhand von Ausführungsformen mit zwei oder vier Schleifenteilen erläutert. Die Erfindung kann aber auch mit einer anderen - insbesondere auch einer ungeraden - Anzahl von Schleifenteilen ausgeführt sein.

**Patentansprüche**

1.  Oberflächenspule für Hochfrequenzmagnetfelder bei Kernspinuntersuchungen mit wenigstens einer in wenigstens zwei kapazitiv miteinander gekoppelte und vorzugsweise gleich lange Teile (4, 7) aufgeteilten Schleife,
    dadurch gekennzeichnet, daß der eine Schleifenteil (7) einen Außenleiter umfaßt, daß im Inneren des Außenleiters in verschiedenen Teilen desselben zwei davon isolierte Innenleiter (51, 61) angeordnet sind, und daß deren einer Anschluß jeweils symmetrisch zu diesem Schleifenteil herausgeführt ist und deren anderer Anschluß jeweils galvanisch mit dem Leiter bzw. den Leitern des benachbarten Schleifenteils (4) bzw. der benachbarten Schleifenteile (10, 11) gekoppelt ist.

2. Oberflächenspule nach Anspruch 1,
dadurch gekennzeichnet, daß der Außenleiter (53, 63) des einen Schleifenteils (7) und der bzw. die Leiter des bzw. der anderen Schleifenteils(e) (4 bzw. 10, 11) zumindest annähernd den gleichen Durchmesser aufweisen.

3. Oberflächenspule nach einem der vorhergehenden Ansprüche,
dadurch gekennzeichnet, daß der eine Schleifenteil (7) von zwei etwa gleich langen Koaxialleitungen (5, 6) gebildet wird, von denen jeweils annähernd gleich lange Teile zusammen den einen Schleifenteil (7) bilden.

4. Oberflächenspule nach Anspruch 3,
dadurch gekennzeichnet, daß die verbleibenden Teile der Koaxialleitungen (5, 6), die nicht den Schleifenteil (7) bilden, nebeneinander und symmetrisch zu dem einen Schleifenteil (7) verlaufen.

5. Oberflächenspule nach Anspruch 3 oder 4,
dadurch gekennzeichnet, daß an die von dem einen Schleifenteil (7) abgewandten Anschlüsse der Koaxialleitungen (5, 6) ein Anpaß- und Abstimmnetzwerk (Cm, Ct, Cs) angeschlossen ist.

6. Oberflächenspule nach Anspruch 5,
dadurch gekennzeichnet, daß das Anpaß- und Abstimmnetzwerk in einer elektrischen Abschirmung (2) angeordnet ist, die galvanisch mit den Außenleitern (53, 63) der Koaxialleitungen (5, 6) verbunden ist.

7. Oberflächenspule nach einem der Ansprüche 3 bis 6,
dadurch gekennzeichnet, daß ein Brückenglied (8) vorgesehen ist, das die Außenleiter der beiden Koaxialleitungen (5, 6) in dem Bereich, in den sie in den einen Schleifenteil (7) übergehen, elektrisch leitend überbrückt.

8. Oberflächenspule nach einem der vorhergehenden Ansprüche mit zwei Schleifenteilen,
dadurch gekennzeichnet, daß die Innenleiter (51, 61) des einen Schleifenteils (7) im Bereich außerhalb des einen Schleifenteils (7), in dem sie mit dem anderen Schleifenteil (4) gekoppelt sind, mit einem Gelenk versehen sind, so daß die Ebenen der beiden Schleifenteile (4, 7) gegeneinander verschwenkbar sind.

9. Oberflächenspule nach einem der Ansprüche 1 bis 7,
dadurch gekennzeichnet, daß die Schleife in eine gerade Zahl von wenigstens vier gleich langen Schleifenteilen (4, 7, 10, 11) aufgeteilt ist, daß die Innenleiter (51, 61) des einen Schleifenteils (7) mit den Außenleitern der benachbarten Schleifenteile (10, 11) verbunden sind, daß die Außenleiter der benachbarten Schleifenteile jeweils in ihrem Inneren einen Innenleiter (101, 111) umschließen, der seinerseits an dem von dem einen Schleifenteil (7) abgewandten Ende mit einem benachbarten Schleifenteil (4) verbunden ist, und daß ein weiterer Schleifenteil auf der dem einen Schleifenteil (7) gegenüberliegenden Seite der Schleife vorgesehen ist, dessen Leiter mit den Innenleitern der beiden Schleifenteile verbunden ist.

10. Oberflächenspule nach Anspruch 1 bis 7,
dadurch gekennzeichnet, daß die Schleife in eine gerade Zahl von wenigstens vier Schleifenteilen unterteilt ist, daß dem einen Schleifenteil (7) ein weiterer Schleifenteil (4') gegenüber liegt, der einen Innenleiter und einen Außenleiter aufweist und so gestaltet ist, daß die zwischen dem Innenleiter und dem Außenleiter wirksame Kapazität zumindestens annähernd die gleiche Größe hat wie die entsprechenden Kapazitäten des einen Schleifenteils (7), und daß sein Innenleiter mit den Leitern der beiderseits benachbarten Schleifenteile (10', 11') verbunden ist.

11. Oberflächenspule nach Anspruch 1 oder 5,
dadurch gekennzeichnet, daß an die Anschlüsse der aus dem einen Schleifenteil (7) herausgeführten Innenleiter (51, 61) ein Abstimm- und ein Anpaßkondensator einerseits (Ct, Cm) und andererseits ein Symmetriekondensator angeschlossen ist, dessen Kapazität der Summe der Kapazitäten des Abstimm- und des Anpaßkondensators entspricht, so daß beide Innenleiter in gleicher Weise kapazitiv belastet sind.

**Claims**

1. A surface coil for high-frequency magnetic fields for nuclear spin examinations, comprising at least one loop which is divided into at least two capacitively coupled, preferably equally long sections (4, 7), characterized in that one loop section (7) is formed by an outer conductor, that within the outer conductor, in different sections thereof, two inner conductors (51, 61) are arranged so as to be insulated therefrom, and that a respective connection thereof is fed out symmetrically with respect to the relevant loop section, the other respective connection thereof being conductively coupled to the conductor or conductors of the neighbouring loop section (4) or the neighbouring loop sections (10, 11).

2. A surface coil as claimed in Claim 1, characterized in that the outer conductors (53, 63) of one loop section (7) and the conductor or conductors of the other loop section (sections) (4, and 10, 11, respectively) have at least approximately the same diameter.

3. A surface coil as claimed in any one of the preceding Claims, characterized in that the one loop section (7) is formed by two approximately equally long coaxial leads (5,6), approximately equally long parts thereof together forming the one loop section (7).

4. A surface coil as claimed in Claim 3, characterized in that the remaining parts of the coaxial leads (5, 6) which do not form the loop section (7) extend adjacently with respect to one another and symmetrically with respect to the one loop section (7).

5. A surface coil as claimed in Claim 3 or 4, characterized in that a matching and tuning network (Cm, Ct, Cs) is connected to the connections of the coaxial leads (5, 6) which are remote from the one loop section (7).

6. A surface coil as claimed in Claim 5, characterized in that the matching and tuning network is arranged within an electrical shield (2) which is conductively connected to the outer conductors (53, 63) of the coaxial leads (5, 6).

7. A surface coil as claimed in any one of the Claims 3 to 6, characterized in that there is provided a bridge member (8) which electrically conductively bridges the outer conductors of the two coaxial leads (5, 6) at the area where they change over into the one loop section (7).

8. A surface coil as claimed in any one of the preceding Claims, comprising two loop sections, characterized in that at the area outside the one loop section (7) in which they are coupled to the other loop section (4) the inner conductors (51, 61) of the one loop section (7) are provided with a swivel so that the planes of the two loop sections (4, 7) can be swiveled with respect to one another.

9. A surface coil as claimed in any one of the Claims 1 to 7, characterized in that the loop is divided into an even number of at least four equally long loop sections (4, 7, 10, 11), the inner conductors (51, 61) of the one loop section (7) being connected to the outer conductors of the neigbouring loop sections (10, 11), the outer conductors of the neigbouring loop sections enclosing a respective inner conductor (101, 111) which itself is connected, at the end which is remote from the one loop section (7), to a neigbouring loop section (4), a further loop section being provided at the side of the loop which is situated opposite the one loop section (7), the conductors of said further loop section being connected to the inner conductors of both loop sections.

10. A surface coil as claimed in the Claims 1 to 7, characterized in that the loop is divided into an even number of at least four loop sections, a further loop section (4') being situated opposite the one loop section (7) and comprising an inner conductor and an outer conductor, said further loop section being constructed so that the capacitance acting between the inner conductor and the outer conductor is at least approximately equal to the corresponding capacitances of the one loop section (7), its inner conductor being connected to the conductors of the neighbouring loop sections (10', 11') at both sides.

11. A surface coil as claimed in Claim 1 or 5, characterized in that to the connections of the inner conductors (51, 61) emerging from the one loop section (7) there is connected on the one side a tuning capacitor and a matching capacitor (Ct, Cm) and on the other side a symmetry capacitor whose capacitance corresponds to the sum of the capacitances of the tuning and the matching capacitor, so that the same capacitive loading is obtained, for both inner conductors.

**Revendications**

1. Bobine de surface pour des champs magnétiques haute fréquence destinés à des examens par résonance magnétique nucléaire, comportant au moins une boucle divisée en au moins deux parties (4, 7) à couplage capacitif mutuel qui sont de préférence de même longueur, caractérisée en ce que l'une des parties de bouche (7) comporte un conducteur extérieur, qu'à l'intérieur du conducteur extérieur, dans des parties différentes de celui-ci, sont disposés deux conducteurs intérieurs (51, 61) qui en sont isolés et que l'une de leurs connexions est chaque fois sortie symétriquement par rapport à cette partie de bouche, tandis que leur autre connexion est chaque fois couplée par voie galvanique au conducteur ou aux conducteurs de la partie de boucle voisine (4) ou des parties de bouche voisines (10, 11).

2. Bobine de surface suivant la revendication 1, caractérisée en ce que le conducteur extérieur (53, 63) de l'une des parties de bouche (7) et le ou les conducteurs de l'autre ou des autres parties de bouche (4 ou 10, 11) présentent au moins à peu prés le même diamètre.

3. Bobine de surface suivant l'une quelconque des revendications précédentes, caractérisée en ce que l'une des parties de bouche (7) est formée de deux lignes coaxiales (5, 6) ayant à peu près la même longueur dont des parties qui ont chaque fois à peu près la même longueur forment ensemble cette partie de bouche (7).

4. Bobine de surface suivant la revendication 3, caractérisée en ce que les parties restantes des lignes coaxiales (5, 6) qui ne forment pas la partie de bouche (7) s'étendent côte à côte et symétriquement par rapport à ladite partie de bouche (7).

5. Bobine de surface suivant la revendication 3 ou 4, caractérisée en ce qu'un réseau d'adaptation et d'accord (Cm, Ct, Cs) est connecté aux connexions des lignes coaxiales (5, 6) qui sont éloignées de ladite partie de bouche (7).

6. Bobine de surface suivant la revendication 5, caractérisée en ce que le réseau d'adaptation et d'accord est disposé dans un blindage électrique (2) qui est connecté par voie galvanique aux conducteurs extérieurs (53, 63) des lignes coaxiales (5, 6).

7. Bobine de surface suivant l'une quelconque des revendications 3 à 6, caractérisée en ce qu'est prévu un élément du pontage (8) qui ponte de manière conductrice électrique les conducteurs extérieurs des deux lignes coaxiales (5, 6), dans la zone dans laquelle elles se fondent dans ladite partie de boucle (7).

8. Bobine de surface suivant l'une quelconque des revendications précédentes, comportant deux parties de boucle, caractérisée en ce que les conducteurs intérieurs (51, 61) de la partie de boucle (7) sont pourvus d'une articulation dans la zone extérieure à ladite partie de boucle (7) dans laquelle ils sont couplés à l'autre partie de boucle (4), de sorte que les plans des deux parties de boucle (4, 7) peuvent pivoter l'un par rapport à l'autre.

9. Bobine de surface suivant l'une quelconque des revendications 1 à 7, caractérisée en ce que la boucle est divisée en un nombre pair d'au moins quatre parties de boucle de même longueur (4, 7, 10, 11), que les conducteurs intérieurs (51, 61) de l'une des parties de boucle (7) sont connectés aux conducteurs extérieurs des parties de boucle voisines (10, 11), que les conducteurs extérieurs des parties de boucle voisines entourent chaque fois intérieurement un conducteur intérieur (101, 111) qui, pour sa part, est connecté par son extrémité éloignée de ladite partie de boucle (7) à une partie de boucle voisine (4) et que, du côté de la boucle opposé à ladite partie de boucle (7) est prévue une autre partie de boucle dont le conducteur est connecté aux conducteurs intérieurs des deux parties de boucle.

10. Bobine de surface suivant les revendications 1 à 7, caractérisée en ce que la boucle est divisée en un nombre pair d'au moins quatre parties de boucle et qu'en face de ladite partie de boucle (7) est située une autre partie de boucle (4') qui comprend un conducteur intérieur et un conducteur extérieur et a une forme telle que la capacité active entre le conducteur intérieur et le conducteur extérieur ait à peu près la même grandeur que les capacités correspondantes de ladite partie de boucle (7) et que son conducteur intérieur est connecté aux conducteurs des parties de boucle voisines des deux côtés (10', 11').

11. Bobine de surface suivant la revendication 1 ou 5, caractérisée en ce qu'aux connexions du conducteur intérieur (51, 61) sortant de ladite partie de boucle (7) sont connectés, d'une part, un condensateur d'accord et un condensateur d'adaptation (Ct, Cm) et, d'autre part, un condensateur de symétrie dont la capacité correspond à la somme des capacités du condensateur d'accord et du condensateur d'adaptation, de sorte que les deux conducteurs intérieurs sont soumis de la même façon à une charge capacitive.

Fig. 1

53

2

1

3

63

4

7

# Fig. 2a

16

2

1

4

51(61)

53(63)

# Fig. 2b

Fig. 3

Fig. 4